# EUROPÄISCHE PATENTSCHRIFT

(11) **EP 2 197 254 B1**
(45) Veröffentlichungstag und Bekanntmachung des Hinweises auf die Patenterteilung: **31.08.2011**
(21) Anmeldenummer: 08021383.8
(22) Anmeldetag: 09.12.2008
(51) Int. Cl.: H05K 7/14

(54) **Elektronikmodul für ein Anlagenmodul**
Electronics module for an assembly module
Module électronique pour un module d'installations

(43) Veröffentlichungstag der Anmeldung: 16.06.2010
(73) Patentinhaber: Siemens Aktiengesellschaft, 80333 München (DE)
(72) Erfinder: Bräunlich, Michael, 09117 Chemnitz (DE); Ott, Thomas, 09306 Rochlitz (DE); Rochlitzer, Daniela, 09114 Chemnitz (DE)

(56) Entgegenhaltungen:
- EP-A- 1 282 346
- EP-A- 1 524 889
- EP-A- 1 583 408

## Beschreibung

Die Erfindung betrifft ein Elektronikmodul, ausgestaltet zum Einstecken in ein Anlagenmodul, mit einem Trennelement, welches während eines Einsteckvorgangs bzw. eines Ziehvorgangs über ein Betätigungsmittel betätigt wird.

Beispielsweise bei Automatisierungskomponenten, welche in explosionsgefährdeter Umgehung eingesetzt werden, müssen Elektronikmodule elektrisch abgeschaltet werden, bevor sie aus einem Anlagenmodul entnommen werden können. Dadurch werden offene Funkenstrecken vermieden, wobei für den Einsatz von Elektronikmodulen unter Explosions-Bedingungen für eine sichere Trennung von Stromkreisen selbst bei relativ geringen Spannungen bereits relativ große Trennabstände, von etwa 2 bis 3 mm, bei Spannungen von 10 bis 30 Volt eingehalten werden müssen.

Bei Elektronikmodulen nach dem Stand der Technik ist auf dem Betätigungsmittel eine Schleifkontaktfeder montiert, welche zwei Zinnkontaktflächen auf einer Leiterplatte überbrückt und das Elektronikmodul damit zuschaltet. Nachteilig an diesem Aufbau ist es, dass diese Art der Kontaktierung verschleißanfällig ist und Kontaktprobleme durch Oxidation, Abrieb an den Kontakten durch beispielsweise industrielle raue Umweltbedingungen wie Staub, chemische Substanzen, aggressive Gase und Vibrationen auftreten können.

Weiterhin wird durch die Einhaltung von vorgegebenen Trennabständen bei bestimmten Anforderungen an die Baugruppe eine Konstruktion eines Trennelementes erschwert und es müsste bei Trennelementen mit Schaltern nach dem Stand der Technik wegen der großen Trennabstände auf eine unverhältnismäßig große Bauform zurückgegriffen werden.

Es ist daher die Aufgabe der Erfindung ein Elektronikmodul bereitzustellen, welches ein Trennelement mit einer geringeren baulichen Ausdehnung aufweist.

Die Aufgabe wird dadurch gelöst, dass das Trennelement einen ersten Anschluss mit einem ersten Kontaktbereich, einem zweiten Anschluss mit einem zweiten Kontaktbereich, ein Schließelement mit einem dritten Kontaktbereich und einem vierten Kontaktbereich aufweist, wobei das Schließelement in einer Trennposition derart angeordnet ist, dass zwischen dem ersten Kontaktbereich und dem dritten Kontaktbereich ein ersten Trennabstand und zwischen dem zweiten Kontaktbereich und dem vierten Kontaktbereich ein zweiter Trennabstand vorhanden ist. Die Aufteilung einer vorgeschriebenen Trennstrecke mit einem vorgeschriebenen Trennabstand in eine erste Teilstrecke mit einem ersten Trennabstand und in eine zweite Teilstrecke mit einem zweiten Trennabstand, beispielsweise bei zwei nebeneinander liegenden Kontaktbereichen, sorgt dafür, dass die Bauform des Trennelementes klein gehalten werden kann. Der zu unterbrechende Stromkreis wird nun nicht mehr mit einem herkömmlichen Schaltelement nur an einer Stelle unterbrochen, sondern er wird gleichzeitig an zwei Stellen unterbrochen, wobei jede dieser zwei Stellen einen Anteil des geforderten Trennabstandes übernehmen kann.

In einer vorteilhaften Ausgestaltung ist das Schließelement zum Übergang von der Trennposition in eine Schließposition beweglich angeordnet. Da bei dem Elektronikmodul vorzugsweise über das Betätigungsmittel zusätzlich eine Modulentriegelung zum Entriegeln des Elektronikmodules aus dem Anlagenmodul realisiert ist, wird ein Verfahrweg des Betätigungsmittels zur Modulentriegelung dafür genutzt das Schließelement von der Trennposition in eine Schließposition zu bringen. Die erforderliche Trennstrecke bzw. der erforderliche Trennabstand ist unter Berücksichtigung seiner Bauformen mit einem zusätzlich geringeren Fahrweg auf die bereits erwähnten zwei Teilstrecken aufgeteilt worden.

Weiterhin ist es von Vorteil, wenn das Schließelement innerhalb eines Führungsmittels angeordnet ist. Die für eine sichere Trennung der Kontakte geforderten mechanischen Anforderungen wie Stabilität und eine geringe Störanfälligkeit werden durch eine Führung des Schließelementes, beispielsweise in einem Kunststoffgehäuse, ermöglicht. Durch das Führungsmittel ist zusätzlich eine genaue Positionierung des Schließelementes zum Betätigungsmittel möglich.

Bei einer weiter optimierten Ausgestaltungsform ist das Schließelement u-förmig ausgestaltet und ein erster Schenkel steht über ein Mittelteil mit einem zweiten Schenkel in Verbindung. Dieses klammerartig ausgestaltete Schließelement stellt vorzugsweise einen Kurzschlussbügel dar, der während eines Schaltvorganges in der Führung eines Gehäuses aus nicht leitendem Material verbleibt. Durch eine zentrale Krafteinleitung am Mittelteil des Schließelementes machen sich vorteilhaft geringe Steck- und Ziehkräfte beim Schaltvorgang bemerkbar.

Um die eingangs genannten Kontaktprobleme weiter zu reduzieren, ist es vom Vorteil, wenn der erste und der zweite Kontaktbereich zur zumindest teilweise umschließenden Aufnahme des dritten bzw. des vierten Kontaktbereiches ausgestaltet ist. Der erste Anschluss und der zweite Anschluss weisen jeweils einen ersten und zweiten Kontaktbereich auf, welcher beispielsweise als eine gabelförmige Kontaktklammer ausgestaltet ist, in denen sich der dritte und vierte Kontaktbereich des Schaltelementes einschieben lässt und durch eine Federspannung der gabelförmig ausgestalteten Kontaktbereiche des ersten und des zweiten Anschlusses sicher gehalten werden.

Weiterhin ist es vorteilhaft, dass das Mittelteil einen Zapfen zum Führen des Schließelementes über das Befestigungsmittel aufweist. Der Zapfen kann in vorteilhafter Weise in eine Führungsnut des Betätigungsmittels eingebracht werden und somit über das Betätigungsmittel präzise von der Trennposition in die Schließposition bewegt werden.

Zur Erhöhung der Robustheit eines solchen Trennelementes innerhalb des Elektronikmodules ist es vorteilhaft, wenn der erste Anschluss, der zweite Anschluss, das Schließelement und das Führungsmittel eine bauliche Einheit bilden. Aufgrund von rauen mechanischen Umweltbedingungen, wie sie beispielsweise in der Industrieautomatisierung vorkommen, ist es sinnvoll wegen der mechanischen Anforderung an die Stabilität und an eine geringe Störanfälligkeit die dafür notwendigen Komponenten vorzugsweise in ein robustes Kunststoffgehäuse als eine bauliche Einheit unterzubringen.

Bei einer weiterführenden Ausgestaltung sind der erste und der zweite Anschluss an einer den Kontaktbereich gegenüberliegenden Seite als abgewinkelte Lötpins zum Auflöten auf eine Leiterplatte ausgestaltet. Beispielsweise fest vergossene erste und zweite Anschlussbeinchen können entsprechend einer Gehäusebauform der baulichen Einheit derart abgewinkelt sein, dass sie auf Lötflächen, welche auf einer Leiterbahn angeordnet sind, aufgelötet werden und somit zu der elektrischen Verbindung gleichzeitig eine mechanische Stabilität hervorrufen.

Um die Stabilität weiter zu erhöhen weist das Trennelement Zusatzlötpins zur Befestigung auf. Diese Zusatzlötpins sind vorzugsweise in den Eckbereichen des Trennelementes angeordnet um eine zusätzliche Stabilität gegen Verrutschen oder Vibrationen zu gewährleisten. Die Zusatzlötpins können wiederum vorzugsweise mit einem Kunststoffgehäuse fest vergossen sein und haben dabei in der Regel keine elektrische Funktion sondern nur eine stabilisierende Wirkung.

Weiterhin ist es von Vorteil, wenn das Trennelement ein Gehäuse aufweist und zur Positionierung des Trennelementes auf der Leiterplatte auf dem Gehäuse ein Stabilisator angeordnet ist, welcher im Eingriff mit der Leiterplatte steht. Solche Stabilisatoren können beispielsweise als Kunststoffzapfen am Gehäuse ausgebildet sein. Diese Kunststoffzapfen können dann im Eingriff mit entsprechenden Löchern auf einer das Trennelement tragenden Leiterplatte stehen und sorgen somit für einen sicheren Halt auch unter Rüttel- und Schockbelastung der Elektronikmodule.

Weiterhin ist es vorteilhaft, dass das Betätigungsmittel zum Reduzieren von mechanischen Einkopplungen in das Trennelement Entkopplungsmittel aufweist. So kann beispielsweise über eine breite Führungsnut, welche sich in dem Betätigungsmittel befindet und im Eingriff mit dem Zapfen des Mittelteils steht, eine mechanische Kopplung der Bewegung vom Betätigungsmittel zum Schließelement erfolgen. Auf die Kontaktbereiche und den entsprechenden Gegenkontaktbereichen des Schließelementes werden damit auch in einem Belastungszustand durch extreme Vibrationen des Anlagenmoduls wenig bis keine Vibrationen auf das Trennelement über das Betätigungsmittel übertragen. Ein Abrieb der Kontaktflächen wird dadurch vermieden.

Weitere Vorteile und Ausgestaltungsmerkmale werden anhand der Zeichnung näher erläutert. Es zeigen:
- FIG 1: ein Elektronikmodul und ein Anlagenmodul,
- FIG 2: ein Trennelement mit einem Schließelement in einer Trennposition,
- FIG 3: das Trennelement mit dem Schließelement in einer Schließposition,
- FIG 4: das Trennelement mit einer Sicht auf eine Unterseite des Trennelementes und
- FIG 5: eine Detailansicht des Elektronikmoduls, wobei an der Stelle des Trennelementes das Gehäuse aufgeschnitten dargestellt ist.

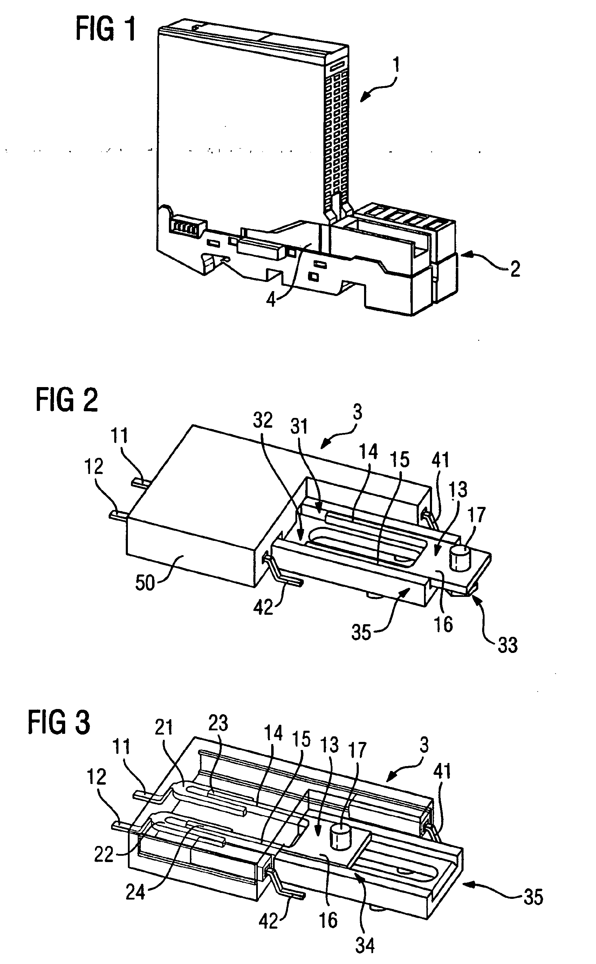

Gemäß FIG 1 ist ein Elektronikmodul 1 in einem gesteckten Zustand in einem Anlagenmodul 2 dargestellt. Das Elektronikmodul 1 ist derart ausgestaltet, dass es in das Anlagenmodul 2 steckbar ist und mit ihm verrastet. Während eines Einsteckvorganges wird ein Betätigungsmittel 4 bewegt, dieses Betätigungsmittel 4 ist wiederum gekoppelt mit einem Trennelement 3 (wie es die Figuren 2 bis 5 zeigen). Derartige Elektronikmodule 1 werden beispielsweise zum Aufbau von modularen Steuerungssystemen oder zum Aufbau von dezentralen Peripheriesystemen in der Prozessautomatisierung verwendet. Die Anlagenmodule 2 sind dazu geeignet, mit einem benachbarten Anlagenmodul verbunden zu werden. Ein Anlagenmodul 2 weist somit eine Schnittstelle zu dem Elektronikmodul 1, sowie beidseitige Kontakte für Steuerungssignale, die sowohl innerhalb des Anlagenmodules elektrisch miteinander verbunden sind als auch elektrische Verbindungen zu der Schnittstelle des Elektronikmoduls aufweisen.

Gemäß FIG 2 ist ein Trennelement 3 zum Schließen und Öffnen eines Stromkreises für das in FIG 1 beschriebene Elektronikmodul 1 dargestellt. Das Trennelement 3 ist üblicherweise in das Elektronikmodul 1 eingebaut. Das Trennelement 3 umfasst ein Kunststoffgehäuse 50 aus dem ein erster Anschluss 11, ein zweiter Anschluss 12, ein erster Zusatzlötpin 41 und ein zweiter Zusatzlötpin 42 als Anschlussstellen herausragen. Der erste Anschluss 11 und der zweite Anschluss 12 ist dabei die Verbindung zu dem aufzutrennenden bzw. zu schließenden Stromkreis. Die FIG 2 zeigt das Trennelement 3 mit einem undurchsichtig dargestellten Gehäuse 50. Zur besseren Veranschaulichung eines Hin- und Herfahrens eines Schließelementes 13 ist in FIG 3 das Trennelement 3 mit dem Gehäuse 50 in durchsichtiger Darstellung abgebildet. In FIG 2 befindet sich das Schließelement 13 in einer Trennposition 33. In dieser Trennposition 33 liegt das Schließelement 13, umfassend einen ersten Schenkel 14, einen zweiten Schenkel 15 und einen Mittelteil 16, in einem Führungsmittel 35. Das Schließelement 13 ist mit dem Führungsmittel 35 derart ausgestaltet, dass es sich von der Trennposition 33 in eine Schließposition 34 verschieben lässt.

In der Trennposition 33 steht ein erster Kontaktbereich 21, welcher mit dem ersten Anschluss 11 in Verbindung steht, einem dritten Kontaktbereich 23 des ersten Schenkels 14 gegenüber und bildet zwischen dem ersten Kontaktbereich 21 und dem dritten Kontaktbereich 23 einen ersten Trennabstand 31. Ein zweiter Kontaktbereich 22, welcher mit dem ersten Anschluss 12 in Verbindung steht, steht einem vierten Kontaktbereich 24 des zweiten Schenkels 15 in einem zweiten Trennabstand 32 gegenüber. Der erste Anschluss 11 und der zweite Anschluss 12 sind somit nicht elektrisch miteinander verbunden und können in der Trennposition 33 des Schaltelementes 13 den Stromkreis nicht schließen. Eine für einen Einsatz eines Elektronikmodules 1 in einem explosionsgefährdeten Bereich vorgegebene Trennstrecke zwischen Stromkreis trennenden bzw. Stromkreis schließenden Kontakten ist durch die Anordnung des Schaltelementes 13 zu dem ersten und zweiten Kontaktbereich 21,22 des ersten Anschlusses 11 und des zweiten Anschlusses 12 auf zwei Teilstrecken aufgeteilt. Ein Wechsel zwischen der Trennposition 33 und der Schließposition 34 des Schließelementes 13 wird durch einen Vergleich der FIG 2 mit der FIG 3 und umgekehrt deutlich.

In FIG 3 ist das Schließelement 13 in einer Schließposition 34 dargestellt. Der erste Schenkel 14 ist mit seinem dritten Kontaktbereich 23 in den ersten Kontaktbereich 21 des ersten Anschlusses 11 eingebettet und der vierte Kontaktbereich 24 des zweiten Schenkels 15 ist in den zweiten Kontaktbereich 22 des zweiten Anschlusses 12 eingebettet. Durch das Einschieben des dritten und des vierten Kontaktbereiches 23,24 in den ersten bzw. zweiten Kontaktbereich 21,22 wird mittels des u-förmig ausgestalteten Schaltelementes 13 der Stromkreis über den ersten Anschluss 11 und den zweiten Anschluss 12 geschlossen.

Ein Hauptteil des Gehäuses 50 ist 1-förmig ausgestaltet und weist Einschuböffnungen für den ersten Schenkel 14 und den zweiten Schenkel 15 in das Gehäuseinnere auf, wobei der erste Kontaktbereich 21 und der zweite Kontaktbereich 23 als ein gabelförmiges Kontaktelement ausgestaltet ist und den Einschuböffnungen zur Aufnahme der dritten und vierten Kontaktbereiche 23,24 des Schaltelementes 13 gegenüberstehend angeordnet sind. Das Führungsmittel 35 ist als eine Führungsschiene mit einem Langloch ausgestaltet, welches den rechteckförmig ausgestalteten Mittelteil 16 des Schaltelementes 3 für eine Linearbewegung sicher führen kann. Das Führungsmittel 35 weist dabei beidseitig Führungsschienen auf, welche derart ausgestaltet sind, dass das Schaltelement 13 unverlierbar mit dem Führungsmittel 35 in Verbindung steht.

Der Mittelteil 16 weist einen Zapfen 17 auf. Dieser Zapfen 17 dient als Angriffspunkt für das Betätigungsmittel 4 um das Schließelement 13 von der Trennposition 33 in die Schließposition 34 zu bewegen.

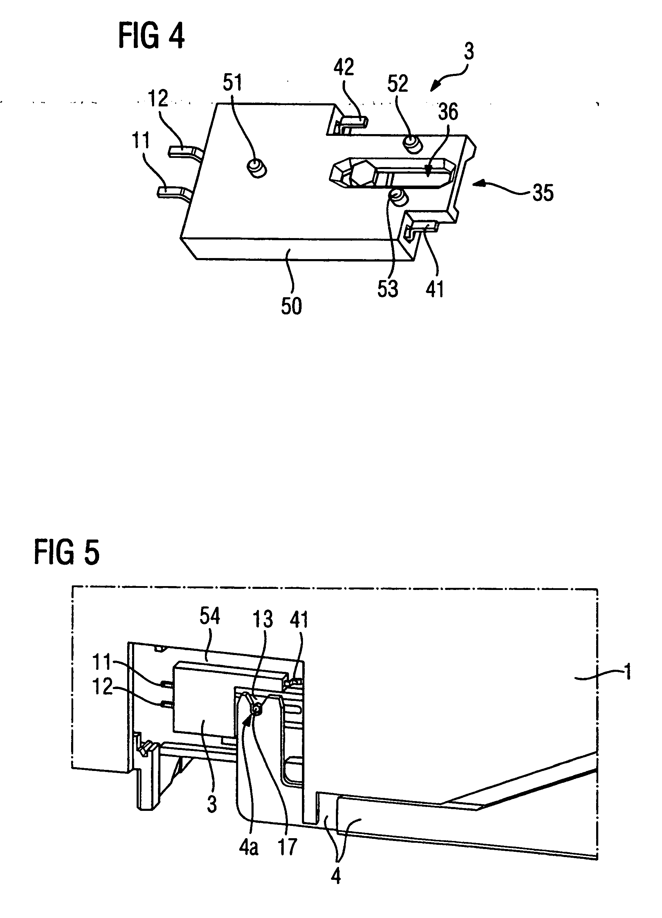

Gemäß FIG 4 ist das aus FIG 2 und 3 bekannte Trennelement 3 in einer Rückansicht dargestellt. Es ist erkennbar, dass der erste Anschluss 11, der zweite Anschluss 12, der erste Zusatzlötpin 41 und der zweite Zusatzlötpin 42 als abgewinkelte Lötpins zum Auflöten auf eine Leiterplatte 54 (siehe FIG 5) ausgestaltet sind. In der rückwärtigen Ansicht des Trennelementes 3 ist das für das Führungsmittel 35 vorgesehene Langloch 36 mit angeschliffenen Kanten versehen. Die gegenüberliegende Seite des Zapfens 17 weist dabei einen Knopf auf, welcher sich in dem Langloch 36 entlang der angeschrägten Kanten spielfrei bewegen lässt und somit zur exakten Positionierung des Schaltelementes 13 und zur Unverlierbarkeit des Schaltelementes 13 beiträgt. Zur Kontaktierung des Trennelementes 13 auf einer Leiterplatte 54 sind die angewinkelten Kontaktpins auf entsprechenden Gegenflächen auf einer Leiterplatte 54, nach FIG 5, fest verlötet. Zur zusätzlichen Stabilisierung, insbesondere im industriellen Einsatz des Elektronikmodules 1, weist die Unterseite des Gehäuses 50 einen ersten Stabilisator 51, einen zweiten Stabilisator 52 und einen dritten Stabilisator 53 auf. Die Stabilisatoren 51,52,53 sind als Wellenstümpfe ausgestaltet und werden in entsprechenden Aufnahmen der Leiterplatte 54 platziert. Mit den zusätzlichen Stabilisatoren 51,52,53 wird die Anfälligkeit des Trennelementes 3 gegen Vibrationen weiter reduziert.

In der FIG 5 ist eine Einbaulage des Trennelementes 3 auf der Leiterplatte 54 des Elektronikmoduls 1 dargestellt. Das Elektronikmodul 1 ist hier in einer Detailvergrößerung als Ausschnitt von dem gesamten Elektronikmodul 1 dargestellt. Ein Elektronikmodulgehäuse ist zur Veranschaulichung an der Einbaustelle des Trennelementes 3 aufgeschnitten dargestellt. Der erste Anschluss 11 ist mit seinem abgewinkelten Lötpin auf die Leiterplatte 54 aufgelötet. Selbiges gilt für die Lötpins des zweiten Anschlusses 12 und des ersten Zusatzlötpins 41.

Das Betätigungselement 4 ist derart angeordnet, dass es über ein Entkopplungsmittel 4a mit dem Schaltelement 13 über den Zapfen 17 in Verbindung steht. Das Entkopplungsmittel 4a ist als eine breite Führungsnut für eine mechanische Entkopplung der Bewegung des Betätigungsmittels 4 ausgestaltet. Eine Rüttel- oder Stoßbelastung wird somit vorteilhafter Weise nicht auf das Schaltelement 13 übertragen. Das Schaltelement 13 verbleibt damit auch in einem Belastungszustand mit seinem dritten und vierten Kontaktbereich 23,24 in den entsprechend gabelförmig ausgestalteten Kontaktbereichen 21,22 des ersten und des zweiten Anschlusses 11, 12.

Mit dieser Ausgestaltung kann für eine Anwendung in explosionsgefährdeten Umgebungen eine geforderte Trennstrecke durch die Aufteilung in eine erste Teilstrecke und eine zweite Teilstrecke auch für ein Trennelement 3 realisiert werden, welches gegenüber einem weiteren Trennelement mit nur einer Trennstrecke eine größere bauliche Ausdehnung haben würde.

## Patentansprüche

1. Elektronikmodul (1), verwendet zum Aufbau von modularen Steuerungssystemen oder zum Aufbau von dezentralen Peripheriesystemen in der Prozessautomatisierung und ausgestaltet zum Einstecken in ein Anlagenmodul (2), mit einem Trennelement (3), welches zum Schließen und Öffnen eines Stromkreises während eines Einsteckvorgangs bzw. eines Ziehvorgangs über ein Betätigungsmittel (4) betätigt wird,
**dadurch gekennzeichnet, dass** das Trennelement (3) einen ersten Anschluss (11) mit einem ersten Kontaktbereich (21), einen zweiten Anschluss (12) mit einem zweiten Kontaktbereich (22), ein Schließelement (13) mit einem dritten Kontaktbereich (23) und einem vierten Kontaktbereich (24) aufweist, wobei das Schließelement (13) in einer Trennposition (33) derart angeordnet ist, dass zwischen dem ersten Kontaktbereich (21) und dem dritten Kontaktbereich (23) ein erster Trennabstand (31) und zwischen dem zweiten Kontaktbereich (22) und dem vierten Kontaktbereich (24) ein zweiter Trennabstand (32) vorhanden ist.

2. Elektronikmodul (1) nach Anspruch 1,
wobei das Schließelement (13) zum Übergang von der Trennposition (33) in eine Schließposition (34) beweglich angeordnet ist.

3. Elektronikmodul (1) nach Anspruch 2,
wobei das Schließelement (13) innerhalb eines Führungsmittels (35) angeordnet ist.

4. Elektronikmodul (1) nach einem der Ansprüche 1 bis 3,
wobei das Schließelement (13) u-förmig ausgestaltet ist und ein erster Schenkel (14) über ein Mittelteil (16) mit einem zweiten Schenkel (15) in Verbindung steht.

5. Elektronikmodul (1) nach einem der Ansprüche 1 bis 4,
wobei der erste und der zweite Kontaktbereich (21,22) zur zumindest teilweise umschließenden Aufnahme des dritten bzw. vierten Kontaktbereichs (23,24) ausgestaltet ist.

6. Elektronikmodul (1) nach Anspruch 4 oder 5, wobei das Mittelteil (16) einen Zapfen (17) zum Führen des Schließelementes (13) über das Betätigungsmittel (4) aufweist.

7. Elektronikmodul (1) nach einem der Ansprüche 3 bis 6, wobei der erste Anschluss (11), der zweite Anschluss (12), das Schließelement (13) und das Führungsmittel (35) eine bauliche Einheit bilden.

8. Elektronikmodul (1) nach einem der Ansprüche 1 bis 6, wobei der erste und der zweite Anschluss (11,12) an einer dem Kontaktbereich (21,22) gegenüberliegenden Seite als abgewinkelte Lötpins zum Auflöten auf eine Leiterplatte (54) ausgestaltet sind.

9. Elektronikmodul (1) nach einem der Ansprüche 1 bis 8, wobei das Trennelement (3) Zusatzlötpins (41,42) zur Befestigung aufweist.

10. Elektronikmodul (1) nach einem der Ansprüche 1 bis 9, wobei das Trennelement (3) ein Gehäuse (50) aufweist und zur Positionierung des Trennelementes (3) auf der Leiterplatte (54) auf diesem ein Stabilisator angeordnet ist, welcher im Eingriff mit der Leiterplatte steht.

11. Elektronikmodul (1) nach einem der Ansprüche 1 bis 10, wobei das Betätigungsmittel (4) zum Reduzieren von mechanischen Einkopplungen in das Trennelement (3) Entkopplungsmittel (4a) aufweist.

## Claims

1. Electronics module (1) used to form modular control systems or to form decentralized peripheral systems for process automation and designed to be plugged into an installation module (2), having an isolating element (3), which is operated via an operating means (4) in order to close and open a circuit during an insertion process and a withdrawal process, respectively,
**characterized in that**
the isolating element (3) has a first connection (11) with a first contact area (21), a second connection (12) with a second contact area (22), a closing element (13) with a third contact area (23) and a fourth contact area (24), wherein the closing element (13) is arranged in a disconnected position (33) such that a first isolation separation (31) is provided between the first contact area (21) and the third contact area (23), and a second isolation separation (32) is provided between the second contact area (22) and the fourth contact area (24).

2. Electronics module (1) according to Claim 1,
wherein the closing element (13) is arranged such that it can move, in order to move from the disconnected position (33) to a closed position (34).

3. Electronics module (1) according to Claim 2,
wherein the closing element (13) is arranged within a guide means (35).

4. Electronics module (1) according to one of Claims 1 to 3, wherein the closing element (13) is U-shaped, and a first limb (14) is connected via a center part (16) to a second limb (15).

5. Electronics module (1) according to one of Claims 1 to 4, wherein the first and the second contact areas (21, 22) are designed to hold the third and fourth contact areas (23, 24), respectively, such that they at least partially surround them.

6. Electronics module (1) according to Claim 4 or 5,
wherein the center part (16) has a pin (17) in order to guide the closing element (13) over the operating means (4).

7. Electronics module (1) according to one of Claims 3 to 6, wherein the first connection (11), the second connection (12), the closing element (13) and the guide means (35) form a physical unit.

8. Electronics module (1) according to one of Claims 1 to 6, wherein the first and the second connections (11, 12) are formed on a side opposite the contact area (21, 22) as angled solder pins for soldering onto a printed circuit board (54).

9. Electronics module (1) according to one of Claims 1 to 8, wherein the isolating element (3) has additional solder pins (41, 42) for attachment.

10. Electronics module (1) according to one of Claims 1 to 9, wherein the isolating element (3) has a housing (50) and a stabilizer is arranged thereon in order to position the isolating element (3) on the printed circuit board (54), and engages with the printed circuit board.

11. Electronics module (1) according to one of Claims 1 to 10, wherein the operating means (4) has decoupling means (4a) in order to reduce mechanical couplings into the isolating element (3).

## Revendications

1. Module ( 1 ) électronique utilisé pour la construction de systèmes modulaires de commande ou pour la construction de systèmes périphériques décentralisés dans l'automatisation de processus et conformé pour être enfiché dans un module ( 2 ) d'installation, comprenant un élément ( 3 ) de séparation qui est actionné par un moyen ( 4 ) d'actionnement pour la fermeture et l'ouverture d'un circuit pendant une opération d'enfichage ou une opération de tirage,
**caractérisé en ce que** l'élément ( 3 ) de séparation a une première borne ( 11 ) ayant une première zone ( 21 ) de contact et une deuxième borne ( 12 ) ayant une deuxième zone ( 22 ) de contact, un élément ( 13 ) de fermeture ayant une troisième zone ( 23 ) de contact et une quatrième zone ( 24 ) de contact, l'élément ( 13 ) de fermeture étant mis dans une position ( 33 ) de séparation de manière à avoir, entre la première zone ( 21 ) de contact et la troisième zone ( 23 ) de contact, une première distance ( 31 ) de séparation et, entre la deuxième zone ( 22 ) de contact et la quatrième zone ( 24 ) de contact, une deuxième distance ( 32 ) de séparation.

2. Module ( 1 ) électronique suivant la revendication 1,
dans lequel l'élément ( 13 ) de fermeture est monté mobile pour le passage de la position ( 33 ) de séparation à une position ( 34 ) de fermeture.

3. Module ( 1 ) électronique suivant la revendication 2,
dans lequel l'élément ( 13 ) de fermeture est placé à l'intérieur d'un moyen ( 35 ) de guidage.

4. Module ( 1 ) électronique suivant l'une des revendications 1 à 3,
dans lequel l'élément ( 13 ) de fermeture est en forme de u et une première branche ( 14 ) est en liaison avec une deuxième branche ( 15 ) par une partie ( 16 ) médiane.

5. Module ( 1 ) électronique suivant l'une des revendications 1 à 4,
dans lequel la première et la deuxième zones ( 21, 22 ) de contact sont conformées pour entourer au moins en partie la troisième et la quatrième zones ( 23, 24 ) de contact.

6. Module ( 1 ) électronique suivant la revendication 4 ou 5, dans lequel la partie ( 16 ) médiane a un tenon ( 17 ) pour le guidage de l'élément ( 13 ) de fermeture par le moyen ( 4 ) d'actionnement.

7. Module ( 1 ) électronique suivant l'une des revendications 3 à 6,
dans lequel la première borne ( 11 ), la deuxième borne ( 12 ), l'élément ( 13 ) de fermeture et le moyen ( 35 ) de guidage forment une unité de construction.

8. Module ( 1 ) électronique suivant l'une des revendications 1 à 6,
dans lequel la première et la deuxième bornes ( 11, 12 ) sont conformées, sur un côté opposé à la zone ( 21, 22 ) de contact, en broche de soudage coudée pour le soudage sur une plaquette ( 54 ) à circuit imprimé.

9. Module ( 1 ) électronique suivant l'une des revendications 1 à 8,
dans lequel l'élément ( 3 ) de séparation a des broches ( 41, 42 ) supplémentaires de soudage pour la fixation.

10. Module ( 1 ) électronique suivant l'une des revendications 1 à 9,
dans lequel l'élément ( 3 ) de séparation comporte un boîtier ( 50 ) et, pour la mise en position de l'élément ( 3 ) de séparation sur la plaquette ( 54 ) à circuit imprimé, un stabilisateur, qui vient en prise avec la plaquette à circuit imprimé, est placé sur celui-ci.

11. Module ( 1 ) électronique suivant l'une des revendications 1 à 10,
dans lequel le moyen ( 4 ) d'actionnement comporte un moyen ( 4a ) de découplage pour la réduction de couplages mécaniques dans l'élément ( 3 ) de séparation.
